# EUROPEAN PATENT APPLICATION

(11) **EP 2 983 062 A1**
(43) Date of publication of application: **10.02.2016**
(21) Application number: 15155495.3
(22) Date of filing: 18.02.2015
(51) Int. Cl.: G06F 1/26, G06F 1/28

(54) **Backup battery**

(30) Priority: 05.08.2014 TW 103126703
(71) Applicant: Quanta Computer Inc., Guishan Township, Taoyuan Country 333 (TW)
(72) Inventor: Yang, Wei-Ting Yen, Taoyuan City 333 (TW)
(74) Representative: Michalski Hüttermann & Partner Patentanwälte mbB

(57) **Abstract**

A backup battery includes a battery cell, a storage medium, and a processor. The storage medium is configured to store a computer program. The processor is configured to execute the computer program so as to monitor the operating state of the battery cell. The processor selectively generates one or more output signals according to the operating state of the battery cell.

## Description

### CROSS REFERENCE TO RELATED APPLICATIONS

This Application claims priority of Taiwan Patent Application No. 103126703 filed on August 5, 2014, the entirety of which is incorporated by reference herein.

### BACKGROUND OF THE INVENTION

### Field of the Invention

The disclosure generally relates to a backup battery, and more particularly, to a smart backup battery for improving system reliability.

### Description of the Related Art

In a large system, a backup battery is used as a simple UPS (Uninterruptible Power Supply), which can provide backup electric power in case of system AC (Alternating Current) power failure. However, the backup battery is kept in a fully charged state and operated in a high-temperature environment, and therefore it has a shorter battery life than a general battery does. As a result, it has become a critical challenge for engineers to design a novel backup battery with high reliability and long usage time.

### BRIEF SUMMARY OF THE INVENTION

In a preferred embodiment, the disclosure is directed to a backup battery including a battery cell, a storage medium, and a processor. The storage medium is configured to store a computer program. The processor is configured to execute the computer program so as to monitor the operating state of the battery cell. The processor selectively generates one or more output signals according to the operating state of the battery cell.

In some embodiments, the processor sets the battery cell to have available capacity which is lower than 80% of its maximum battery capacity, and when the battery cell is charged up to 70% of its maximum charge, the processor outputs a full-charge indication signal. In some embodiments, when remaining charge of the battery cell is lower than 30% of its maximum charge, the processor outputs a first level signal. In some embodiments, when remaining charge of the battery cell is lower than 50% of its maximum charge, the processor outputs a second level signal. In some embodiments, when the battery cell has been used for 5 years or more, the processor outputs a third level signal. In some embodiments, when a voltage, a current, or a temperature of the battery cell is greater than an acceptable value, the processor outputs a temporary failure signal. In some embodiments, when a fuse connected to the battery cell melts, the processor outputs a permanent failure signal. In some embodiments, when a 180-day period has expired and remaining charge of the battery cell is lower than 70% of its maximum charge, the processor calibrates an open-circuited voltage, a self-discharging rate, and an impedance value of the battery cell. In some embodiments, the battery cell provides electric power for a system end, and when the processor receives a power-down signal from the system end, the processor controls the battery cell to stop providing the electric power. In some embodiments, the processor further controls a light-emitting diode to generate a flash-light signal according to the output signals.

### BRIEF DESCRIPTION OF DRAWINGS

The invention can be more fully understood by reading the subsequent detailed description and examples with references made to the accompanying drawings, wherein:
FIG. 1 is a diagram of a backup battery according to an embodiment of the invention;
FIG. 2 is a diagram of a backup battery according to an embodiment of the invention;
FIG. 3 is a flowchart of a charging process of a backup battery according to an embodiment of the invention;
FIG. 4A and FIG. 4B are a flowchart of a discharging process of a backup battery according to an embodiment of the invention; and
FIG. 5 is a flowchart of a calibrating process of the backup battery according to an embodiment of the invention.

### DETAILED DESCRIPTION OF THE INVENTION

In order to illustrate the purposes, features and advantages of the invention, the embodiments and figures of the invention are shown in detail as follows.

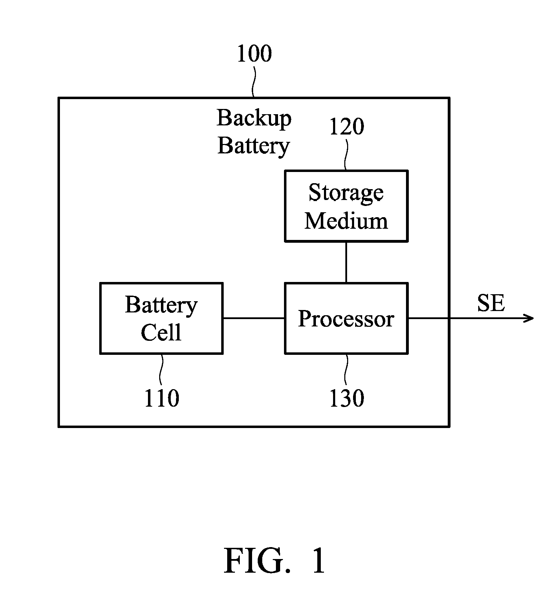

FIG. 1 is a diagram of a backup battery 100 according to an embodiment of the invention. The backup battery 100 may be applied to a large system or a POS (Point of Sales) system and used to provide backup electric power. As shown in FIG. 1, the backup battery 100 includes a battery cell 110, a storage medium 120, and a processor 130. The battery cell 110 may include multiple electric power storage elements coupled in series, and may be used to perform general battery-charging or battery-discharging functions. The storage medium 120 may be a register or a memory for storing a computer program. The processor 130 can execute the computer program of the storage medium 120 so as to monitor the operating state of the battery cell 110. The processor 130 can selectively generate one or more output signals SE according to the operating state of the battery cell 110, and therefore a system connected to the backup battery 100 can obtain operating state information of the battery cell 110 according to the output signals SE.

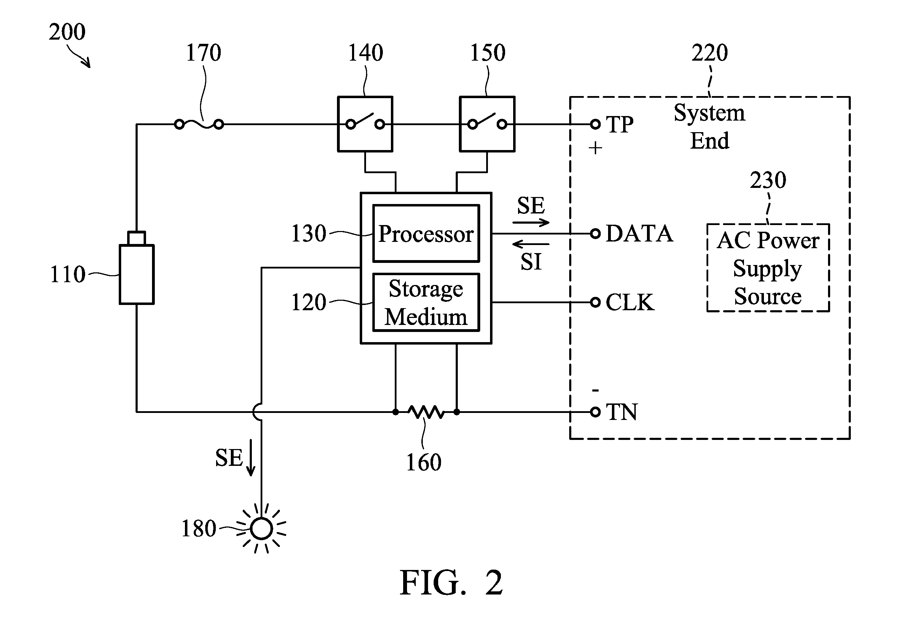

FIG. 2 is a diagram of a backup battery 200 according to an embodiment of the invention. FIG. 2 further describes the inner structure of the backup battery 200 in detail. In the embodiment of FIG. 2, the backup battery 200 includes a battery cell 110, a storage medium 120, a processor 130, a charging switch 140, a discharging switch 150, a detection resistor 160, and a fuse 170. The functions of the battery cell 110, the storage medium 120, and the processor 130 have been described in the embodiments of FIG. 1. Each of the charging switch 140 and the discharging switch 150 may be implemented with a MOSFET (Metal-Oxide-Semiconductor Field-Effect Transistor). The processor 130 controls the power supply mode of the backup battery 200 by switching the charging switch 140 and the discharge switch 150. The processor 130 further obtains voltage and current information of the battery cell 110 by monitoring the voltage and current of the detection resistor 160. The fuse 170 is configured to prevent the battery cell 110 from loading large current and being broken. In some embodiments, the backup battery 200 further includes a thermometer for detecting the environmental temperature (not shown).

In some embodiments, the backup battery 200 is connected to a system end 220. The system end 220 may be a large system or a POS system. Normally, the system end 220 is supplied by an AC power supply source 230. If a power-down event happens to the AC power supply source 230, the backup battery 200 will supply backup electric power to the system end 220 for final data storage. More particularly, a positive output terminal TP and a negative output terminal TN of the backup battery 200 are both connected to the system end 220, and therefore these terminals provide a backup output voltage difference therebetween. In addition, a data transmission terminal DATA and a clock transmission terminal CLK of the backup battery 200 are also connected to the system end 220, such that the system end 220 can communicate and exchange signal contents with the backup battery 200 through these transmission terminals. Since the system end 220 is usually located in a high-temperature and closed environment and the backup battery 200 out of use is always kept in a full-power state, the environmental condition tends to shorten the usage time of the backup battery 200. In order to solve the problem, the invention provides a smart design, which causes the processor 130 of the backup battery 200 to output the output signals SE relative to the battery cell 110 automatically. As a result, the system end 220 can analyze the output signals SE and obtain operating state information of the battery cell 110. If the battery cell 110 is aged or has insufficient capacity, the system end 220 will be notified of the fact and make necessary preparations in advance. In some embodiments, the processor 130 is further connected to a display device, and the display device shows the operating state information of the battery cell 110 according to the output signals SE. In alternative embodiments, the processor 130 further controls an LED (Light-Emitting Diode) 180 to generate a flash-light signal according to the output signals SE. The operator can understand, by reading the message shown on the display device or LED, whether the backup battery 200 needs fixing or replacing.

The following embodiments describe a variety of output signals SE which are outputted by the processor 130. It should be understood that the embodiments are just exemplary, rather than limitations of the invention.

The output signals SE of the processor 130 include a full-charge signal, a first level signal, a second level signal, a third level signal, a temporary failure signal, and a permanent failure signal. In order to increase the safety margin, the battery cell 110 may be downgraded for use, and the processor 130 may set the battery cell 110 to have available capacity which is lower than 80% of its maximum battery capacity. For example, if the battery cell 110 has maximum battery capacity of 2800mAh (Milliampere*Hour), the processor 130 may set the available capacity of the battery cell 110 to 2200mAh (2200/2800 = 78.6% <80%). In other words, the maximum charge of the battery cell 110 is 2200mAh, rather than original 2800mAh. When the battery cell 110 is charged up to 70% of its maximum charge, the processor 130 outputs a full-charge indication signal. The 70% full-charge indication can prevent the backup battery 200 from always being charged up to 95% of its maximum charge, as with a conventional battery. Therefore, the backup battery 200 of the invention can have longer usage time. In alternative embodiments, the 70% full-charge indication may be replaced with an 80% or 60% full-charge indication, and a similar level of performance may be also achieved. The processor 130 may include a built-in counter. When the counter indicates that the battery cell 110 has been used for 5 years or more (or it exceeds a period of 5 years after the battery cell 110 left the factory), the processor 130 outputs a third level signal (Level 3). The processor 130 may further monitor the remaining charge of the battery cell 110. When the remaining charge of the battery cell 110 is lower than 50% of its maximum charge, the processor 130 outputs a second level signal (Level 2). In addition, when the remaining charge of the battery cell 110 is lower than 30% of its maximum charge, the processor 130 outputs a first level signal (Level 1). The above level signals are used to remind the operator of the safety condition of the battery cell 110. The priority from high to low is the first level signal, the second level signal, and the third level signal. For example, if the processor 130 outputs the first level signal, it means that the remaining charge of the battery cell 110 is not enough for the system end 220 to perform the final data storage process, and the operator should immediately replace the backup battery 200 so as to avoid data loss. On the other hand, when the voltage, the current, or the temperature of the battery cell 110 is greater than an acceptable value, the processor 130 outputs a temporary failure signal, indicating that the backup battery 200 should be out of use for a period of time for recovery. When a fuse 170 connected to the battery cell 110 melts, the processor 130 outputs a permanent failure signal, indicating that the backup battery 200 is broken and is no longer available. The above steps of monitoring battery state and outputting signals can be performed by writing appropriate computer program codes into the storage medium 120 and by executing the computer program codes with the processor 130. In alternative embodiments, the storage medium 120, the processor 130, and the computer program codes are implemented with specific combinational logic circuits and sequential circuits.

In some embodiments, the LED 180 displays different output signals SE as Table I.

**Table I: Different Output Signals Displayed by LED**

| Frequency of flash-light signal | Meaning |
|---|---|
| Blinking once every 0.5 seconds | Temporary failure signal |
| Kept dark | Third level signal |
| Blinking once every 2 seconds | Second level signal |
| Blinking once every 1 seconds | First level signal |
| Blinking once every 5 seconds | Permanent failure signal |

In alternative embodiments, the system end 220 displays different output signals SE as indicated in Table II.

**Table II: Different Output Signals Displayed by System End**

| Relative percentage of maximum charge | Meaning |
|---|---|
| 100% | Full-charge indication signal |
| 70% | Ready to perform calibrating process |
| 50% | Second level signal |
| 30% | First level signal |

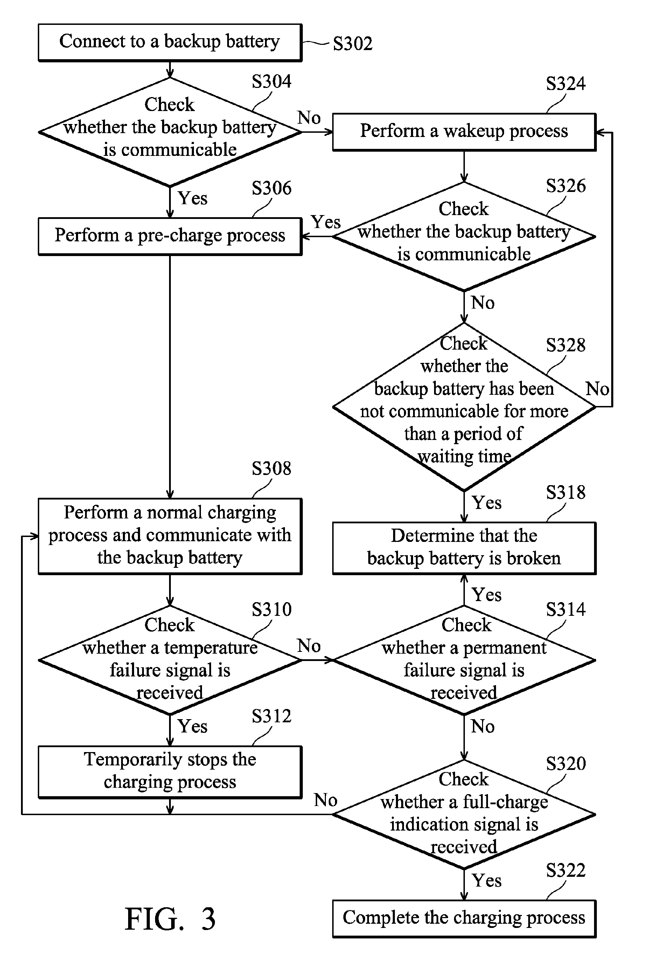

FIG. 3 is a flowchart of a charging process of the backup battery 200 according to an embodiment of the invention. To begin, in step S302, the backup battery 200 is connected to the system end 220. In step S304, the system end 220 transmits signals through the data transmission terminals DATA, and checks whether the backup battery 200 is communicable. If so, in step S306, the system end 220 performs a pre-charge process to the backup battery 200. Next, in step S308, the system end 220 performs a normal charging process to the backup battery 200, and continues to communicate with the backup battery 200 through the data transmission terminals DATA (e.g., the system end 220 may transmit a system signal S1 to the backup battery 200, and the backup battery 200 may transmit one or more output signals SE to the system end 220, such that they can communicate with each other). In step S310, the system end 220 checks whether a temporary failure signal is received from the backup battery 200. If so, in step S312, the system end 220 temporarily stops charging the backup battery 200, and the procedure goes back to step S308. If not, in step S314, the system end 220 checks whether a permanent failure signal is received from the backup battery 200. If so, in step S318, the system end 220 determines that the backup battery 200 is broken and no longer available. If not, in step S320, the system end 220 checks whether a full-charge indication signal is received from the backup battery 200. If not, the procedure goes back to S308. If so, in step S322, the system end 220 determines that the charging process is completed. On the other hand, if in step S304 the system end 220 determines that the backup battery 200 is not communicable, in step S324, the system end 220 performs a wakeup process to the backup battery 200. Next, in step S326, the system end 220 rechecks whether the backup battery 200 is communicable. If so, the procedure goes to step S306. If not, in step S328, the system end 220 checks whether the backup battery 200 has been not communicable for more than a period of waiting time. If not, the procedure goes back to step S324. If so, in step S318, the system end 220 determines that the backup battery 200 is broken and no longer available. In some embodiments, the system end 220 and the backup battery 200 form an uninterruptible power supply system, and the system end 220 further includes a system storage medium for storing computer program codes and a system processor for executing the program and performing every step of the disclosure.

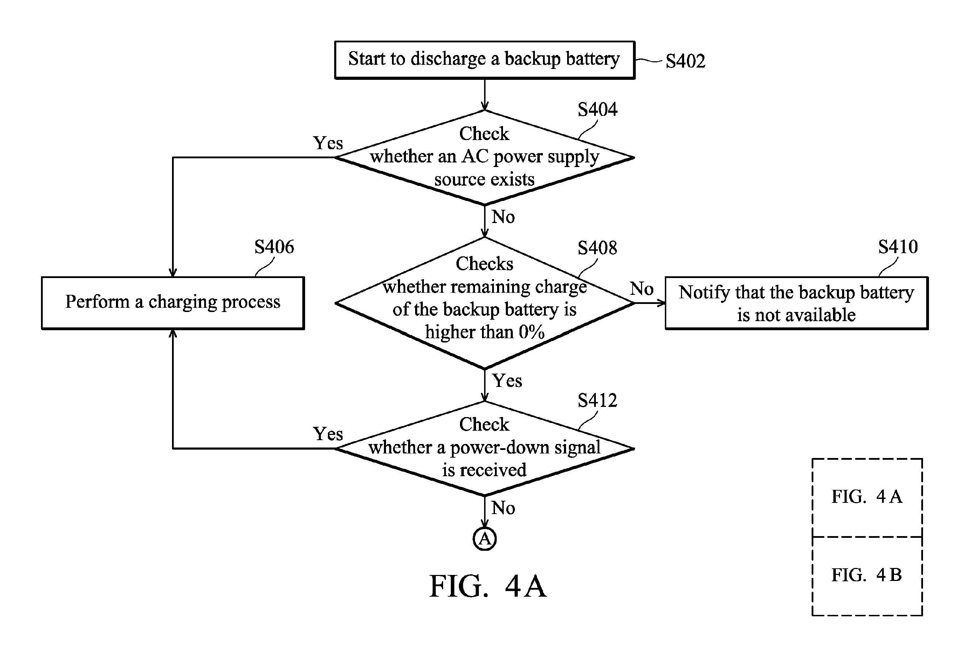

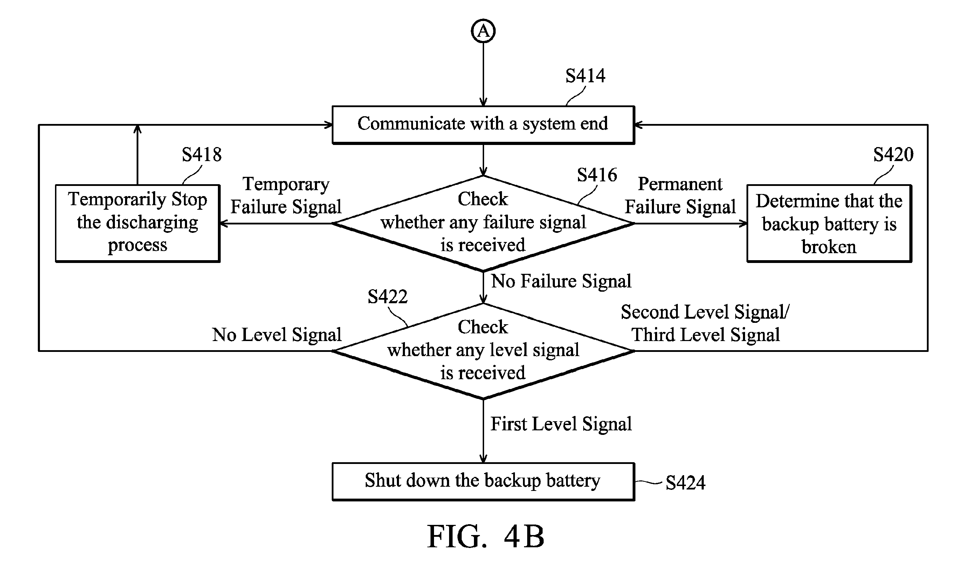

FIG. 4A and FIG. 4B are a flowchart of a discharging process of the backup battery 200 according to an embodiment of the invention. To begin, in step S402, the backup battery 200 starts to discharge. At the time, the backup battery 200 should be connected to the system end 220. In step S404, the processor 130 of the backup battery 200 checks whether an AC power supply source 230 exists and works normally. If so, in step S406, the system end 220 performs a charging process to the backup battery 200. The charging process has been described in the embodiment of FIG. 3. If not, in step S408, the processor 130 checks whether the remaining charge of the battery cell 110 is higher than 0%. If not, in step S410, the processor 130 notifies the system end 220 that the backup battery 200 is not available. If so, in step S412, the processor 130 checks whether a power-down signal is received from the system end 220. If so, in step S406, the processor 130 controls the battery cell 110 to stop providing electric power, and the system end 220 performs a charging process to the backup battery 200. If not, in step S414, the processor 130 communicates with the system end 220 through the data transmission terminals DATA (e.g., the system end 220 may transmit a system signal S1 to the backup battery 200, and the backup battery 200 may transmit one or more output signals SE to the system end 220, such that they can communicate with each other). In some embodiments, when the system end 220 has used the electric power of the backup battery 200 to complete the final data storage process, the system end 220 transmits a power-down signal to the backup battery 200 to stop the discharging process. After then, the backup battery 200 may reinstate to a charging state. In step S416, the system end 220 checks whether a temporary failure signal or a permanent failure signal is received from the backup battery 200. If the temporary failure signal is received, in step S418, the system end 220 controls the backup battery 200 to temporarily stop discharging, and the procedure goes back to step S414. If the permanent failure signal is received, in step S420, the system end 220 determines that the backup battery 200 is broken and no longer available. If no failure signal is received, in step S422, the system end 220 checks whether a first level signal, a second level signal, or a third level signal is received from the backup battery 200. If the second level signal or the third level signal is received, or if no level signal is received, it means that the battery cell 110 is normal, old, or low-charge but still available, and the procedure goes back to step S414. If the first level signal is received, it means that the remaining charge of the backup battery 200 is not enough to complete the final data storage process, and in step S424, the system end 220 shuts down the backup battery 200.

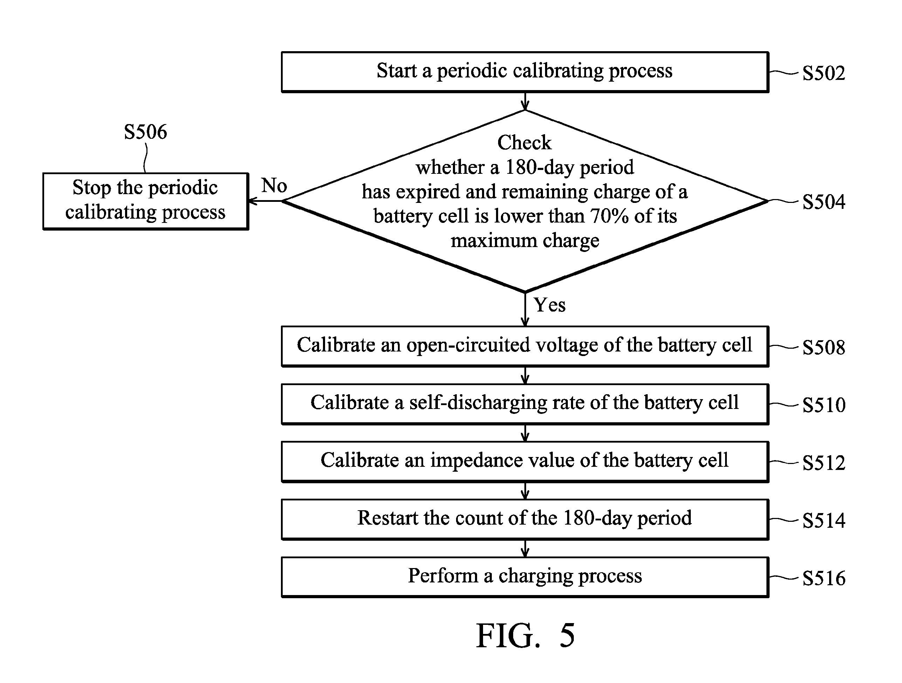

FIG. 5 is a flowchart of a calibrating process of the backup battery 200 according to an embodiment of the invention. To begin, in step S502, the processor 130 of the backup battery 200 starts a periodic calibrating process. In step S504, the processor 130 checks whether a 180-day period has expired and the remaining charge of the battery cell 110 is lower than 70% of its maximum charge. For example, a built-in counter of the processor 130 may count the 180-day period. If not, in step S506, the processor 130 stops the periodic calibrating process. If so, in step S508, the processor 130 calibrates the open-circuited voltage of the battery cell 110 according to the usage time of the battery cell 110. In some embodiments, if the usage time of the battery cell 110 is relatively long, the processor 130 may decrease the open-circuited voltage of the battery cell 110, and if the usage time of the battery cell 110 is relatively short, the processor 130 may increase the open-circuited voltage of the battery cell 110. The relationship between the usage time and the open-circuited voltage may be determined by a first database which is stored in the storage medium 120. Next, in step S510, the processor 130 calibrates the self-discharging rate of the battery cell 110 according to the environmental temperature. In some embodiments, if the environmental temperature is relatively high, the processor 130 may increase the self-discharging rate of the battery cell 110, and if the environmental temperature is relatively low, the processor 130 may decrease the self-discharging rate of the battery cell 110. The relationship between the environmental temperature and the self-discharging rate may be determined by a second database which is stored in the storage medium 120. Then, in step S512, the processor 130 calibrates the impedance value of the battery cell 110 according to the environmental temperature and the remaining charge of the battery cell 110. In some embodiments, if the environmental temperature is relatively low, the processor 130 may increase the impedance value of the battery cell 110, and if the environmental temperature is relatively high, the processor 130 may decrease the impedance value of the battery cell 110. In addition, if the remaining charge of the battery cell 110 is relatively high, the processor 130 may decrease the impedance value of the battery cell 110, and if the remaining charge of the battery cell 110 is relatively low, the processor 130 may increase the impedance value of the battery cell 110. The relationship between the environmental temperature, the remaining charge, and the impedance value may be determined by a third database which is stored in the storage medium 120. Finally, in step S514, the processor 130 resets the built-in counter to restart the count of 180-day period, and in step S516, the processor 130 notifies the system end 220 to perform a charging process. The above calibrating process may be performed about every 0.5 years, and it can ensure that the relative parameters of the battery cell 110 are kept in an acceptable range.

The invention provides a smart back battery which can automatically output its battery state information to a system end according to its own status. Therefore, the system end and the operator can understand the operating state and reduce the risk that the backup battery is old or over its normal usage time and cannot work normally. In addition, by performing the above charging, discharging, and calibrating processes, the backup battery can be well monitored during its usage time and maintained at good performances.

Note that the above parameters are not limitations of the invention. An engineer can adjust these settings or values according to different requirements. It is understood that the backup battery of the invention are not limited to the configurations of FIGS. 1-5. The invention may merely include any one or more features of any one or more embodiments of FIGS. 1-5. In other words, not all of the features shown in the figures should be implemented in the backup battery of the invention.

The method of the invention, or certain aspects or portions thereof, may take the form of a program code (i.e., executable instructions) embodied in tangible media, such as floppy diskettes, CD-ROMS, hard drives, or any other machine-readable storage medium, wherein, when the program code is loaded into and executed by a machine, such as a computer, the machine thereby becomes an apparatus for practicing the methods. The methods may also be embodied in the form of a program code transmitted over some transmission medium, such as electrical wiring or cabling, through fiber optics, or via any other form of transmission, wherein, when the program code is received and loaded into and executed by a machine, such as a computer, the machine becomes an apparatus for practicing the disclosed methods. When implemented on a general-purpose processor, the program code combines with the processor to provide a unique apparatus that operates analogously to application specific logic circuits.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

It will be apparent to those skilled in the art that various modifications and variations can be made in the invention. It is intended that the standard and examples be considered as exemplary only, with a true scope of the disclosed embodiments being indicated by the following claims and their equivalents.

## Claims

1. A backup battery, comprising:
a battery cell;
a storage medium, storing a computer program; and
a processor, executing the computer program so as to monitor an operating state of the battery cell, wherein the processor selectively generates one or more output signals according to the operating state of the battery cell.

2. The backup battery as claimed in claim 1, wherein the processor sets the battery cell to have available capacity which is lower than 80% of its maximum battery capacity, and wherein when the battery cell is charged up to 70% of its maximum charge, the processor outputs a full-charge indication signal.

3. The backup battery as claimed in any of the previous claims, wherein when remaining charge of the battery cell is lower than 30% of its maximum charge, the processor outputs a first level signal.

4. The backup battery as claimed in any of the previous claims, wherein when remaining charge of the battery cell is lower than 50% of its maximum charge, the processor outputs a second level signal.

5. The backup battery as claimed in any of the previous claims, wherein when the battery cell has been used for 5 years or more, the processor outputs a third level signal.

6. The backup battery as claimed in any of the previous claims, wherein when a voltage, a current, or a temperature of the battery cell is greater than an acceptable value, the processor outputs a temporary failure signal.

7. The backup battery as claimed in any of the previous claims, wherein when a fuse connected to the battery cell melts, the processor outputs a permanent failure signal.

8. The backup battery as claimed in any of the previous claims, wherein when a 180-day period has expired and remaining charge of the battery cell is lower than 70% of its maximum charge, the processor calibrates an open-circuited voltage, a self-discharging rate, and an impedance value of the battery cell.

9. The backup battery as claimed in any of the previous claims, wherein the battery cell provides electric power for a system end, and wherein when the processor receives a power-down signal from the system end, the processor controls the battery cell to stop providing the electric power.

10. The backup battery as claimed in any of the previous claims, wherein the processor further controls a light-emitting diode to generate a flash-light signal according to the output signals.

## Amended claims

### Amended claims in accordance with Rule 137(2) EPC.

1. A backup battery (100), comprising:
a battery cell (110);
a storage medium (120), storing a computer program; and
a processor (130), executing the computer program so as to monitor an operating state of the battery cell (110), wherein
the processor (130) selectively generates one or more output signals according to the operating state of the battery cell (110), and wherein
when a 180-day period has expired and remaining charge of the battery cell (110) is lower than 70% of its maximum charge, the processor (130) calibrates an open-circuited voltage, a self-discharging rate, and an impedance value of the battery cell (110).

2. The backup battery (100) as claimed in claim 1, wherein the processor (130) sets the battery cell (110) to have available capacity which is lower than 80% of its maximum battery capacity, and wherein when the battery cell (110) is charged up to 70% of its maximum charge, the processor (130) outputs a full-charge indication signal.

3. The backup battery (100) as claimed in any of the previous claims, wherein when remaining charge of the battery cell (110) is lower than 30% of its maximum charge, the processor (130) outputs a first level signal.

4. The backup battery (100) as claimed in any of the previous claims, wherein when remaining charge of the battery cell (110) is lower than 50% of its maximum charge, the processor (130) outputs a second level signal.

5. The backup battery (100) as claimed in any of the previous claims, wherein when the battery cell (110) has been used for 5 years or more, the processor (130) outputs a third level signal.

6. The backup battery (100) as claimed in any of the previous claims, wherein when a voltage, a current, or a temperature of the battery cell (110) is greater than an acceptable value, the processor (130) outputs a temporary failure signal.

7. The backup battery (100) as claimed in any of the previous claims, wherein when a fuse (170) connected to the battery cell (110) melts, the processor (130) outputs a permanent failure signal.

8. The backup battery (100) as claimed in any of the previous claims, wherein the battery cell (110) provides electric power for a system end (220), and wherein when the processor (130) receives a power-down signal from the system end (220), the processor (130) controls the battery cell (110) to stop providing the electric power.

9. The backup battery (100) as claimed in any of the previous claims, wherein the processor (130) further controls a light-emitting diode (180) to generate a flash-light signal according to the output signals.
